# EUROPEAN PATENT APPLICATION

(11) **EP 4 428 906 A1**
(43) Date of publication of application: **11.09.2024**
(21) Application number: 22890283.9
(22) Date of filing: 28.10.2022
(51) Int. Cl.: H01L 21/67, H01J 37/32, H01L 21/3065

(54) **SUBSTRATE PROCESSING DEVICE AND SUBSTRATE PROCESSING METHOD**

(30) Priority: 02.11.2021 KR 20210149132
(71) Applicant: PSK Inc., Hwaseong-si, Gyeonggi-do 18449 (KR)
(72) Inventor: YOO, Kwang Sung, Hwaseong-si Gyeonggi-do 18849 (KR); NAM, Seong Min, Hwaseong-si Gyeonggi-do 18849 (KR); OH, Yong Ik, Hwaseong-si Gyeonggi-do 18849 (KR)
(74) Representative: Harrison IP Limited
(86) International application number: PCT/KR2022/016637
(87) International publication number: WO 2023/080548

(57) **Abstract**

The present invention provides a device for processing a substrate. The device for processing a substrate may comprise: a housing having an inner space; a chuck for supporting a substrate in the inner space; a gas supply unit for supplying process gas to an edge region of the substrate; an edge electrode for generating plasma from the process gas at the edge region of the substrate supported by the chuck; and a dielectric plate facing the substrate supported by the chuck, wherein the dielectric plate is movably divided.

## Description

### [Technical Field]

The present invention relates to a substrate processing apparatus and a substrate processing method.

### [Background Art]

Plasma refers to an ionized gas state formed of ions, radicals, electrons, and the like, and is generated by a very high temperature, strong electric fields, or RF electromagnetic fields. A semiconductor device manufacturing process includes an ashing or etching process of removing a membrane on a substrate by using plasma. The ashing or etching process is performed when ions and radical particles contained in the plasma collide or react with the membrane on the substrate. The process of processing the substrate by using the plasma is performed by various methods.

In a method of processing a substrate by using plasma, a bevel etch process generates plasma at an edge region of a substrate to remove a thin film on the edge region of the substrate.

In performing the bevel etch process, it is necessary to adjust a size and a position of a region in which the plasma is generated (so-called process region) as needed. In general, the size and position of the process region are adjusted by replacing the configuration of the bevel etch device, but the time required to replace the configuration causes reduction of the substrate processing efficiency.

### [Technical Problem]

An object of the present invention is to provide a substrate processing apparatus and a substrate processing method, which are capable of efficiently processing a substrate.

Another object of the present invention is to provide a substrate processing apparatus capable of maintaining a desired gap between a substrate and a dielectric plate, and a control method of the substrate processing apparatus.

Another object of the present invention is to provide a substrate processing apparatus and a substrate processing method, which are capable of changing a size of a region in which plasma is generated.

Another object of the present invention is to provide a substrate processing apparatus and a substrate processing method that provide an additional control factor capable of controlling a flow of plasma.

The problem to be solved by the present invention is not limited to the above-mentioned problems, and the problems not mentioned will be clearly understood by those skilled in the art from the present specification and the accompanying drawings.

### [Technical Solution]

An exemplary embodiment of the present invention provides an apparatus for processing a substrate, the apparatus including: a housing having an internal space; a chuck for supporting a substrate in the internal space; a gas supply unit for supplying process gas to an edge region of the substrate; and an edge electrode for generating plasma from said process gas to an edge region of said substrate supported on said chuck; and a dielectric plate facing said substrate supported on said chuck, said dielectric plate being movably segmented.

According to the exemplary embodiment, the apparatus may further include a moving module provided on top of said dielectric plates, and for moving positions of said segmented dielectric plates.

According to the exemplary embodiment, the moving module may include: a body to which the segmented dielectric plates are coupled; and a moving member installed in the body, and for moving at least one of the segmented dielectric plates.

According to the exemplary embodiment, the body may include: a through groove formed while penetrating a top surface and a bottom surface of the body; and an insertion groove formed in a region including the through groove when viewed from above, and recessed a set depth from the top surface of the body.

According to the exemplary embodiment, the insertion groove may be provided with the moving member.

According to the exemplary embodiment, the moving member may be a piezo motor, and the apparatus may further include a power source for applying power to the moving member.

According to the exemplary embodiment, a size of the insertion groove viewed from above may be greater than a size of the moving member before the power is applied and may be less than a size of the moving member after the power is applied.

According to the exemplary embodiment, the plurality of through grooves and the plurality of insertion grooves may be formed in the body and may be spaced apart from each other along a circumferential direction of the body when viewed from above.

According to the exemplary embodiment, the edge electrode may include: an upper edge electrode having a shape surrounding the dielectric plate, when viewed from above, and configured to be spaced apart from the dielectric plate; and a lower edge electrode having a shape surrounding the chuck, when viewed from above, and disposed below the substrate supported on the chuck.

According to the exemplary embodiment, the gas supply unit may be configured to supply the process gas to a space between the upper edge electrode and the dielectric plate.

According to the exemplary embodiment, the apparatus may further include a controller, in which the controller may control the power source such that a gap between the dielectric plate and the upper edge electrode is a first gap when a first substrate is placed in the chuck, and controls the power source such that the gap between the dielectric plate and the upper edge electrode is a second gap that is different from the first gap when a second substrate that is different from the first substrate is placed in the chuck.

According to the exemplary embodiment, the apparatus may further include a controller, in which the controller may control the gas supply unit to generate the plasma in the edge region of the substrate supported on the chuck, and control the power source so that the gap between the dielectric plate and the upper edge electrode is changed during processing of the substrate by the plasma.

According to the exemplary embodiment, a top surface of any one of the segmented dielectric plates may have a stepped shape so as to overlap a bottom surface of the other of the segmented dielectric plates, when viewed from above.

According to the exemplary embodiment, when viewed from above, a width of a region of the stepped top surface facing the bottom surface may be greater than a gap between the dielectric plates moved by the moving module.

According to the exemplary embodiment, a bottom surface of any one of the segmented dielectric plates may have a stepped shape so as to overlap a top surface of the other of the segmented dielectric plates, when viewed from above.

According to the exemplary embodiment, when viewed from above, a width of a region of the stepped bottom surface facing the top surface may be greater than a gap between the dielectric plates moved by the moving module.

According to the exemplary embodiment, the dielectric plate may have a circular plate shape with an opening formed in a central region, and a bottom surface of a first dielectric plate among the segmented dielectric plates may have a stepped shape so as to overlap a top surface of the second dielectric plate adjacent to the first dielectric plate, and a top surface of the first dielectric plate may have a stepped shape so as to overlap a bottom surface of a fourth dielectric plate adjacent to the first dielectric plate at an opposite side to the second dielectric plate.

Another exemplary embodiment of the present invention provides a method of processing a substrate by using a substrate processing apparatus including a chuck for supporting a substrate, an edge electrode for generating plasma in an edge region of the substrate, a dielectric plate disposed to face a top surface of the substrate supported on the chuck, the dielectric plate being movable in a lateral direction, a moving module for moving the dielectric plate, a gas supply unit for supplying process gas excited to a plasma state to the edge region of the substrate supported on the chuck - the gas supply unit being configured to supply the process gas to a space between the edge electrode and the dielectric plate, the method including: generating plasma in an edge region of a substrate supported on a chuck, and moving at least one of the segmented dielectric plates in a lateral direction to regulate a region in which the plasma is generated and a supply flow rate at which the process gas is supplied per unit time.

According to the exemplary embodiment, moving of the dielectric plate may be performed while the plasma is generated and the substrate is processed.

According to the exemplary embodiment, the method may include moving at least one of the segmented dielectric plates so that a gap between the dielectric plate and the edge electrode is a first gap when the substrate supported on the chuck is a first substrate, and a gap between the dielectric plate and the edge electrode is a second gap that is different from the first gap when the substrate supported on the chuck is a second substrate that is different from the first substrate.

### [Advantageous Effects]

According to the exemplary embodiment of the present invention, it is possible to efficiently treat a substrate.

Further, according to the exemplary embodiment of the present invention, it is possible to change the position of the plasma generated at the edge region of the substrate.

Further, according to the exemplary embodiment of the present invention, it is possible to change the size of the region in which the plasma is generated.

Further, according to the exemplary embodiment of the present invention, it is possible to provide additional control factors capable of controlling flow of the plasma.

The effect of the present invention is not limited to the foregoing effects, and the not-mentioned effects will be clearly understood by those skilled in the art from the present specification and the accompanying drawings.

### [Description of Drawings]

FIG. 1 is a diagram schematically illustrating a substrate processing facility according to an exemplary embodiment of the present invention.
FIG. 2 is a cross-sectional view illustrating an exemplary embodiment of a substrate processing apparatus provided to a process chamber of FIG. 1.
FIG. 3 is a diagram illustrating a dielectric plate and a moving module of FIG. 2 viewed from above.
FIG. 4 is a diagram illustrating any one of parts of a segmented dielectric plate of FIG. 3.
FIG. 5 is a diagram illustrating portions of cross-sections of a first dielectric plate and a fourth dielectric plate of FIG. 3.
FIG. 6 is a diagram illustrating an example of the moving module of FIG. 3 moving the segmented dielectric plates.
FIG. 7 is a diagram illustrating some of the cross-sections of the first dielectric plate and the fourth dielectric plate when the segmented dielectric plates of FIG. 3 are moved.
FIG. 8 is a diagram illustrating the substrate processing apparatus of FIG. 2 performing a plasma treatment process.
FIG. 9 is a diagram illustrating another view of the substrate processing apparatus of FIG. 2 performing a plasma treatment process.

### [Best Mode]

Hereinafter, an exemplary embodiment of the present invention will be described more fully hereinafter with reference to the accompanying drawings, in which exemplary embodiments of the invention are illustrated. However, the present invention can be variously implemented and is not limited to the following exemplary embodiments. In the following description of the present invention, a detailed description of known functions and configurations incorporated herein is omitted to avoid making the subject matter of the present invention unclear. In addition, the same reference numerals are used throughout the drawings for parts having similar functions and actions.

Unless explicitly described to the contrary, the word "include" will be understood to imply the inclusion of stated elements but not the exclusion of any other elements. It will be appreciated that terms "including" and "having" are intended to designate the existence of characteristics, numbers, operations, operations, constituent elements, and components described in the specification or a combination thereof, and do not exclude a possibility of the existence or addition of one or more other characteristics, numbers, operations, operations, constituent elements, and components, or a combination thereof in advance.

Singular expressions used herein include plurals expressions unless they have definitely opposite meanings in the context. Accordingly, shapes, sizes, and the like of the elements in the drawing may be exaggerated for clearer description.

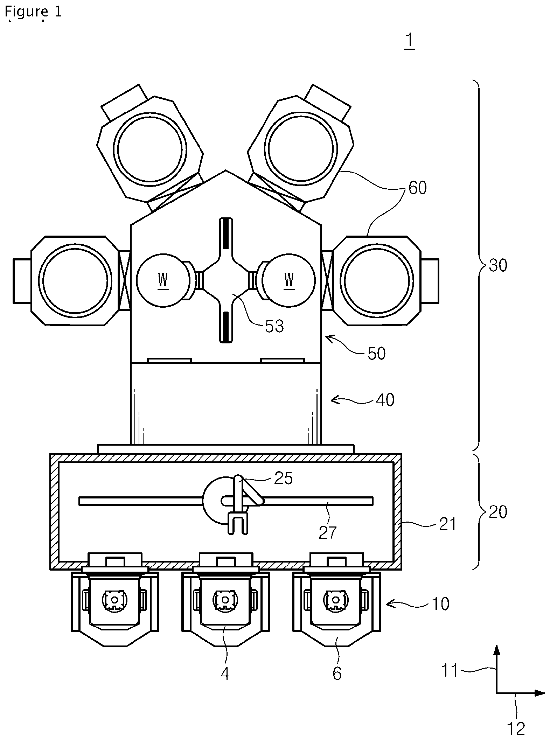

Hereinafter, an exemplary embodiment of the present invention will be described in detail with reference to FIGS. 1 to 9.

FIG. 1 is a diagram schematically illustrating a substrate processing facility according to an exemplary embodiment of the present invention. Referring to FIG. 1, substrate processing equipment 1 has an equipment front end module (EFEM) 20 and a processing module 30. The EFEM 20 and the processing module 30 are disposed in one direction.

The EFEM 20 includes a load port 10 and a transfer frame 21. The load port 10 is disposed in front of the EFEM 20 in a first direction 11. The load port 10 includes a plurality of support parts 6. The support parts 6 are disposed in series in a second direction 12, and a carrier 4 (for example, a cassette, and an FOUP) in which a substrate W that is to be provided for a process and a processing completed substrate W is accommodated is seated on each support unit 6. In the carrier 4, the substrate W that is to be provided for a process and the process completed substrate W are accommodated. The transfer frame 21 is disposed between the load port 10 and the processing module 30. The transfer frame 21 includes a first transfer robot 25 which is disposed inside the transfer frame 21 and transfers the substrate W between the load port 10 and the processing module 30. The first transfer robot 25 moves along a transfer rail 27 provided in the second direction 12 to transfer the substrate W between the carrier 4 and the processing module 30.

The processing module30 includes a load lock chamber 40, a transfer chamber 50, and a process chamber 60. The processing module 30 may treat the substrate W by receiving the substrate W from the EFEM 20.

The load lock chamber 40 is disposed to be adjacent to the transfer frame 21. For example, the load lock chamber 40 may be disposed between the transfer chamber 50 and the EFEM 20. The load lock chamber 40 provides a place in which the substrate W to be provided for the process stands by before being transferred to the process chamber 60, or the processing completed substrate W stands by before being transferred to the EFEM 20.

The transfer chamber 50 may transfer the substrate W. The transfer chamber 50 is disposed to be adjacent to the load lock chamber 40. The transfer chamber 50 has a polygonal body when viewed from above. Referring to FIG. 1, the transfer chamber 50 has a pentagonal body when viewed from above. At the external side of the body, the load lock chamber 40 and the plurality of process chambers 60 are disposed along a circumference of the body. A passage (not illustrated) through which the substrate W enters and exists is formed on each sidewall of the body, and the passage connects the transfer chamber 50 and the load lock chamber 40 or the process chambers 60. Each passage is provided with a door (not illustrated) which opens/closes the passage to seal the interior. The second transfer robot 53 which transfers the substrate W between the load lock chamber 40 and the process chambers 60 is disposed in an internal space of the transfer chamber 50. The second transfer robot 53 transfers the untreated substrate W waiting in the load lock chamber 40 to the process chamber 60 or transfers the process completed substrate W to the load lock chamber 40. Further, the second transfer robot 53 may bring the substrate W into an internal space 102 of a housing 100 which is to be described below, or take out the substrate W from the internal space 102. Further, the second transfer robot 53 may transfer the substrate W between the process chambers 60 in order to sequentially provide the plurality of process chambers 60 with the substrate W. As illustrated in FIG. 1, when the transfer chamber 50 has the pentagonal body, the load lock chamber 40 is disposed on the sidewall adjacent to the EFEM 20, and the process chambers 60 are consecutively disposed on the remaining sidewalls. The transfer chamber 50 may be provided in various forms depending on a demanded process module, as well as the foregoing shape.

The process chamber 60 may be disposed to be adjacent to the transfer chamber 50. The process chambers 60 are disposed along the circumference of the transfer chamber 50. The plurality of process chambers 60 may be provided. In each process chamber 60, the process processing may be performed on the substrate W. The process chamber 60 may receive the substrate W from the second transfer robot 53 and perform the process processing, and provides the second transfer robot 53 with the substrate W for which the process processing is completed. The process processing performed in the respective process chambers 60 may be different from each other.

Hereinafter, a substrate processing apparatus 1000 performing a plasma process in the process chamber 60 will be described. Further, the present invention will be described based on the example in which the substrate processing apparatus 1000 is configured to perform a plasma treating process on an edge region of a substrate among the process chambers 60. However, the present invention is not limited thereto, and the substrate processing apparatus 1000 which is to be described below may be equally or similarly applied to various chambers in which substrate processing is performed. Further, the substrate processing apparatus 1000 may be equally or similarly applied to various chambers in which a plasma treating process is performed on the substrate.

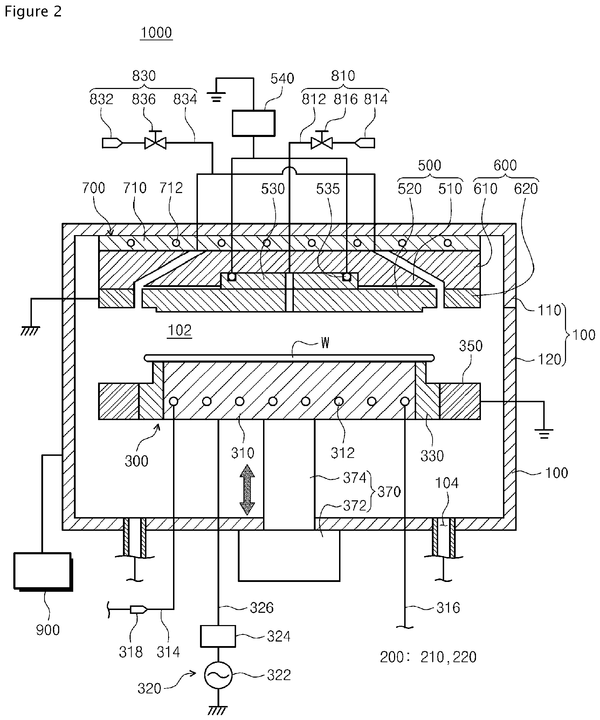

FIG. 2 is a diagram illustrating the substrate processing apparatus provided to a process chamber of FIG. 1 according to an exemplary embodiment. Referring to FIG. 2, the substrate processing apparatus 1000 provided in the process chamber 60 performs a predetermined process on the substrate W by using plasma. For example, the substrate processing apparatus 1000 may etch or ash a film on the substrate W. The film may be various types of membrane, such as a poly silicon film, a silicon oxide film, a silicon nitride film. Further, the film may be a natural oxide film or a chemically produced oxide film. Further, the film may be a by-product generated in a process of processing the substrate W. Further, the film may be impurities attached and/or left on the substrate W.

The substrate processing apparatus 1000 may perform a plasma process on the substrate W. For example, the substrate processing apparatus 1000 may supply process gas and generate plasma from the supplied process gas to treat the substrate W. The substrate processing apparatus 1000 may supply process gas and generate plasma from the supplied process gas to treat an edge region of the substrate W. Hereinafter, the substrate processing apparatus 1000 will be described as a bevel etch apparatus that performs an etching treatment on an edge region of the substrate W by way of example.

The substrate processing apparatus 1000 may include a housing 100, a support unit 300, a dielectric plate unit 500, an upper electrode unit 600, a temperature adjusting unit 700, a gas supply unit 800, and a controller 900.

The housing 100 may define the internal space 102. The housing 100 may include an upper housing 110 (an example of a first housing) and a lower housing 110 (an example of a second housing). The upper housing 110 and the lower housing 120 may be combined with each other to define the internal space 102. Further, the upper housing 110 may be rotatably engaged with the lower housing 120 by a rotary engagement part (not illustrated). For example, the upper housing 110 and the lower housing 120 may be engaged by a rotary coupling part, which may be a hinge mechanism.

Additionally, the internal space 102 may be isolated from the outside, and the externally isolated internal space 102 may be adjusted to a low-pressure state (a near-vacuum atmosphere) close to vacuum while the substrate W is being processed. Further, the housing 100 may be made of a material including metal. Further, an inner surface of the housing 100 may be coated with an insulating material. Further, the housing 100 may be grounded.

Further, the housing 100 may be a vacuum chamber. For example, an exhaust hole 104 may be formed in a bottom surface of the housing 100. Plasma P generated in the internal space 102 or gas G1 and G2 supplied to the internal space 102 may be exhausted to the outside through the exhaust hole 104. Further, by-products generated in the process of processing the substrate W by using the plasma P may be discharged to the outside through the exhaust hole 104. Additionally, the exhaust hole 104 may be connected to an exhaust line (not illustrated). The exhaust line may be connected to a decompression member that provides decompression. The decompression member may provide decompression to the internal space 102 through the exhaust line.

The support unit 300 may support the substrate W in the internal space 102. The support unit 300 may include a chuck 310, a power member 320, an insulating ring 330, a lower edge electrode 350, and a drive member 370.

The chuck 310 may support the substrate W in the internal space 102. The chuck 310 may have a support surface supporting the substrate W. The chuck 310 may have a circular shape when viewed from above. The chuck 310 may have a diameter smaller than a diameter of the substrate W when viewed above. Accordingly, a center region of the substrate W supported by the chuck 310 is seated on the support surface of the chuck 310, and an edge region of the substrate W may not be in contact with the support surface of the chuck 310.

A heating means (not illustrated) may be provided inside the chuck 310. The heating means (not illustrated) may heat the chuck 310. The heating means may be a heater. Further, a cooling flow path 312 may be formed in the chuck 310. The cooling flow path 312 may be formed inside the chuck 310. A cooling fluid supply line 314 and a cooling fluid discharge line 316 may be connected to the cooling flow path 312. The cooling fluid supply line 314 may be connected with a cooling fluid supply source 318. The cooling fluid supply source 318 may store a cooling fluid and/or supply a cooling fluid to the cooling fluid supply line 314. Further, the cooling fluid supplied to a cooling flow path 312 may be discharged to the outside through the cooling fluid discharge line 316. The cooling fluid stored in and/or supplied by the cooling fluid supply source 318 may be cooling water or cooling gas. Further, the shape of the cooling flow path 312 formed in the chuck 310 is not limited to the shape illustrated in FIG. 2, and may be variously transformed. Further, the configuration for cooling the chuck 310 is not limited to a configuration that provides a cooling fluid, but may be provided in a variety of configurations (for example, a cooling plate) that is capable of cooling the chuck 310.

The power supply member 320 may supply RF power to the chuck 310. The power supply member 320 may include a power supply 322, a matcher 324, and a power supply line 326. The power supply 322 may be a bias power supply. Further, the power supply 332 may be an RF power supply. The power supply 322 may be connected with the chuck 310 via the power supply line 326. Further, the matcher 324 is provided to the power supply line 326 to perform impedance matching.

The insulating ring 330 may be provided to have a ring shape when viewed from above. For example, the insulating ring 330 may be provided to surround the chuck 310 when viewed from above. For example, the insulating ring 330 may have a ring shape. The insulating ring 330 may be made of a material having an insulating property.

The lower edge electrode 350 may be formed to surround the insulating ring 330 when viewed from above. The lower edge electrode 350 may have a ring shape when viewed from above. The lower edge electrode 350 may be grounded. The lower edge electrode 350 may generate plasma P at an edge region of the substrate W.

The driving member 370 may lift the chuck 310. The driving member 370 may include a driver 372 and a shaft 374. The shaft 374 may be coupled with the chuck 310. The shaft 374 may be connected with the driver 372. The driver 372 may move up and down the chuck 310 in the vertical direction via the shaft 374. The driving member 370 moves up and down the chuck 310, so that a gap between the top surface of the substrate W supported by the chuck 310 and a bottom surface of a dielectric plate 520 may be adjusted.

The dielectric plate unit 500 may include a first base 510, a dielectric plate 520, a moving module 530, and a power source 540. The dielectric plate unit 500 may be coupled to a temperature control plate 710, which is to be described later, and be fixedly coupled to the upper housing 110.

The first base 510 may be coupled to the temperature adjusting plate 710, which is to be described later. At a lower portion of the first base 510, the moving module 530 may be coupled. The dielectric plate 520 may be coupled to the lower portion of the moving module 530. The dielectric plate 520 may be segmented as described later, and may be provided while being spaced apart from the first base 510 to be movable laterally.

The diameter of the first base 510 may gradually increase from top to bottom. The top surface of the first base 510 may have a smaller diameter than the bottom surface of the first base 510. The top surface of the first base 510 may have a flat shape. Further, a bottom surface of the first base 510 may have a stepped shape. For example, the bottom surface of the first base 510 may be stepped so that a height of the bottom surface of the edge region of the first base 510 is smaller than a height of the bottom surface of the center region. The moving module 530, which is to be described later, may be inserted into a stepped region of the first base 510.

The dielectric plate 520 may be coupled to the lower portion of the moving module 530. The dielectric plate 520 may be disposed so that the bottom surface thereof faces a top surface of the chuck 310. The dielectric plate 520 may have a circular shape when viewed from above. Further, the top surface of the dielectric plate 520 may be stepped such that a height of a center region thereof is higher than a height of an edge region thereof. Further, the bottom surface of the dielectric plate 520 may be provided in a flat shape. Further, the edge region in the bottom surface of the dielectric plate 520 may be stepped so that the height thereof is higher than a height of the center region thereof. The plasma P, which is to be described later, is allowed to enter the stepped region in the bottom surface of the dielectric plate 520 to increase processing efficiency for the edge region of the substrate W.

The dielectric plate 520 may be disposed so as to face the top surface of the substrate W supported by the support unit 300, particularly, the chuck 310, in the internal space 102. The dielectric plate 520 may be disposed above the support unit 300. The dielectric plate 520 may be made of a material including ceramic. The dielectric plate 520 may have a gas flow path formed therein that is in fluid communication with a first gas supply unit 810 of the gas supply unit 800, which is to be described later. The gas flow path may be in communication with an opening formed in the center region of the body 531 of the moving module 530, which is to be described later.

Further, a discharge end of the gas flow path may be configured so that first gas G1 supplied by the first gas supply unit 810 is supplied to the center region of the substrate W supported by the support unit 300. Further, the discharge end of the gas flow path may be configured so that the first gas G1 is supplied to the top surface of the center region of the substrate W supported by the support unit 300.

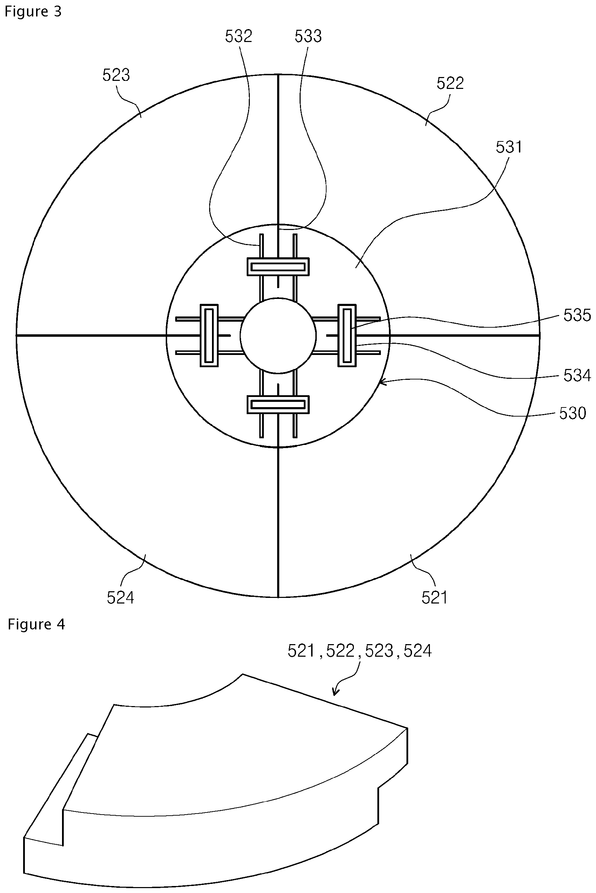

FIG. 3 is a diagram illustrating the dielectric plate and the moving module of FIG. 2 viewed from above.

Referring to FIG. 3, the dielectric plate 520 according to the exemplary embodiment of the present invention may be provided as a segmented body. For example, the dielectric plate 520 may be segmented into four sections. The dielectric plate 520 may include a first dielectric plate 521, a second dielectric plate 522, a third dielectric plate 523, and a fourth dielectric plate 524. Each of the segmented dielectric plates 520 may have an arc shape. Further, the segmented dielectric plates 520 may be independently coupled to the body 531 of the moving module 530.

The first dielectric plate 521, the second dielectric plate 522, the third dielectric plate 523, and the fourth dielectric plate 524 may, in combination with each other, have a donut shape with a gas flow path formed in the center region when viewed from above. The first dielectric plate 521, the second dielectric plate 522, the third dielectric plate 523, and the fourth dielectric plate 524 may be arranged along a circumferential direction of the outer circumference of the body 531 of the moving module 530, which is to be described later, when viewed from above.

The first dielectric plate 521, the second dielectric plate 522, the third dielectric plate 523, and the fourth dielectric plate 524 may have the same or at least similar shapes to each other. Accordingly, the following description will focus on the shapes of the first dielectric plate 521 and the fourth dielectric plate 524 and will omit repeated descriptions of the remaining parts of the segmented dielectric plate 520.

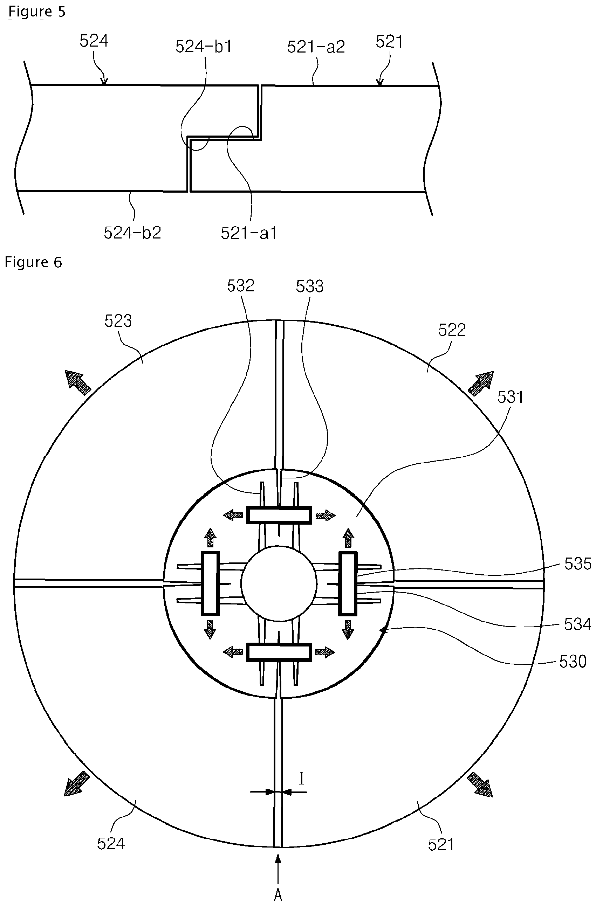

FIG. 4 is a diagram illustrating any one of the parts of the segmented dielectric plate of FIG. 3, and FIG. 5 is a diagram illustrating portions of cross-sections of the first dielectric plate and the fourth dielectric plate of FIG. 3.

The dielectric plate 520, as a whole, may have the shape of a circular plate with an opening formed in the center region thereof. That is, the dielectric plate 520 may have a ring shape when viewed from above. The dielectric plate 520 may be divided into equal sized pieces when viewed from above. For example, the first dielectric plate 521, which is one of the segmented parts of the dielectric plate 520, may have an arc shape.

Further, the upper and bottom surfaces of the first dielectric plate 521 may each have a stepped shape.

For example, the top surface of the first dielectric plate 521 may have a stepped shape so as to overlap the bottom surface of the fourth dielectric plate 524, which is disposed adjacent to the first dielectric plate 521 and opposite the second dielectric plate 522. For example, the top surface of the first dielectric plate 521 may include a first-1 surface 521-a1 and a first-2 surface 521-a2. The first-1 top surface 521-a1 may have a higher height than the first-2 top surface 521-a2.

For example, the top surface of the first dielectric plate 521 may have a stepped shape so as to overlap the top surface of the second dielectric plate 522, which is disposed adjacent to the first dielectric plate 521 and opposite the fourth dielectric plate 524. For example, the bottom surface of the first dielectric plate 521 may include a first-1 bottom surface and a first-2 bottom surface. A height of the first-2 bottom surface is higher than a height of the first-1 bottom surface.

Further, the second dielectric plate 522, the third dielectric plate 523, and the fourth dielectric plate 524 may have substantially the same or similar shapes as the first dielectric plate 521.

The first-1 top surface 521-a1 of the first dielectric plate 521 may overlap with a fourth-1 bottom surface 524-b1 of the fourth dielectric plate 524 when viewed from above. Furthermore, when viewed above, the width in which the first-1 top surface 521-a1 of the first dielectric plate 521 faces the fourth-1 bottom surface 524-b1 of the fourth dielectric plate 524 may be greater than a distance by which the first dielectric plate 521 and the fourth dielectric plate 524 are separated from each other (that is, the distance that the segmented dielectric plate is moved), as described later.

Referring again to FIG. 3, the moving module 530 may include the body 531 and a moving member 535. The moving module 530 may be disposed on top of the segmented dielectric plates 521 to move the position of the segmented dielectric plates 521 in a lateral direction (that is, in a direction parallel to the top surface of the substrate W).

The body 531 may have a donut shape with an opening that is in fluid communication with the gas flow path and is formed in the center region, when viewed from above. The outer circumference of the body 531 may have a substantially circular shape when viewed from above. The body 531 may be coupled to each of the segmented dielectric plates 521. Further, the body 531 may be coupled to the first base 510 described above.

The body 531 may have a first through groove 532, a second through groove 533, and an insertion groove 534 formed therein. The first through groove 532 and the second through groove 533 may be formed extending from above surface of the body 531 to the bottom surface (that is, penetrating the top and bottom surfaces of the body 531). The first through groove 532 may be formed extending from an inner side than the outer circumference of the body 531 to an inner circumference of the body 531. The second through groove 533 may be formed extending from an outer side than the inner circumference of the body 531 to an outer circumference of the body 531. The first through groove 532 may be provided in a pair, and the single second through groove 533 may be formed between the pair of first through grooves 532.

When viewing the pair of first through grooves 532 and the one second through groove 533 as a group of through grooves, a plurality of the through groove groups may be provided, and the through groove groups may be spaced apart from each other along a circumferential direction relative to the center of the body 531 when viewed from above.

Additionally, the body 531 may be provided from a material including metal. When the body 531 is provided from a material including metal, even though the body 531 is slightly deformed, the resilience of the material may allow the body 531 to return to its original shape.

Further, the insertion groove 534 may be formed by being recessed a set depth from above surface of the body 531. The set depth may be a depth at which the insertion groove 534 does not penetrate the bottom surface of the body 531. In the insertion groove 534, the moving member 535 may be placed.

The insertion groove 534 may have a longitudinal direction perpendicular to the direction in which the first through groove 532 and the second through groove 533 extend, when viewed from above. The insertion grooves 534 may be provided in plurality, and may be formed in a region in which one through groove group described above is formed. The insertion grooves 534 may be formed in a region that includes a pair of first through grooves 532 and the second through groove 533.

The moving member 535 may be installed in the body 531. The moving member 535 may be inserted into the insertion groove 534. The moving member 535 may be a piezo motor having a piezo element that may change in size by receiving power from the power source 540, which may be a direct current or alternating current power source. Further, the moving member 535 may be provided in plurality. For example, the moving members 535 may be provided in numbers corresponding to the number of insertion grooves 534.

The size of the insertion groove 534 described above may be larger than the size of the moving member 535 before the power source 540 applies power to the moving member 535, and slightly smaller than the size of the moving member 535 after the power is applied.

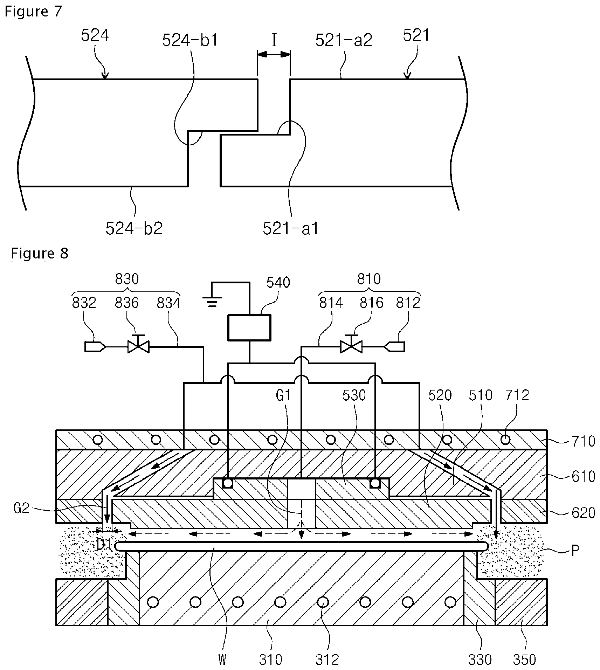

Accordingly, when power is applied to the moving member 535, the first through groove 532 and the second through groove 533 are subjected to a gap, so that the dielectric plate 520 may be moved in the lateral direction. For example, when power is applied to the moving member 535, the segmented dielectric plates 520 may be moved away from the center of the body 531, as illustrated in FIGS. 6 and 7. In this case, when the segmented dielectric plates 520 are maximally moved, a gap I between the adjacent dielectric plates 520 may be less than the width of the stepped region of the dielectric plates 520 (for example, the width of the first-1 top surface 521-a1, or the width of the fourth-1 bottom surface 524-b1). For example, the gap I may be 0.3 to 0.5 mm. The width of the stepped region of the dielectric plate 520 may be larger than the gap I.

This means that when the gap I between the segmented dielectric plates 520 is larger than the width of the stepped region of the dielectric plate 520, the plasma P, which is to be described later, may enter the gap between the segmented dielectric plates 520 and etch some of the configurations of the dielectric plate unit 500. However, in the present invention, the relative distance by which the segmented dielectric plates 520 move is less than the width of the steeped region of the dielectric plate 520, and the dielectric plates 520 have the stepped shape that is a stepped machined structure, thereby minimizing the occurrence of the above problem.

When the application of power to the moving member 535 is stopped, the dielectric plates 520 may be moved to be closer to the center of the body 531, as illustrated in FIG. 3, by the resilience of the body 531 as described above.Referring again to FIG. 2, the upper electrode unit 600 may include a second base 610 and an upper edge electrode 620. Further, the upper electrode unit 600 may be coupled to the temperature adjustment plate 710, which is to be described later. The upper edge electrode 620 may be grounded. The upper edge electrode 620 may have a shape surrounding the dielectric plate 520 when viewed from above. The upper edge electrode 620 may be provided to be spaced apart from the dielectric plate 520. The upper edge electrode 620 may be spaced apart from the dielectric plate 520 to form a space. The gap space may form a part of the gas channel in which second gas G2 supplied by the second gas supply unit 830, which will be described below, flows. A discharge end of the gas channel may be configured so that the second gas G2 is supplied to the edge region of the substrate W supported by the support unit 300. Further, the discharge end of the gas channel may be configured so that the second gas G2 is supplied to the upper surface of the edge region of the substrate W supported by the support unit 300.

The upper edge electrode 620 may be formed to surround the dielectric plate 520 when viewed from above. The upper edge electrode 620 may have a ring shape when viewed from above. The upper edge electrode 620 may be grounded. The upper edge electrode 620 may be disposed above an edge region of the substrate W supported by the chuck 310 when viewed from above. The upper edge electrode 620 may generate plasma P at the edge region of the substrate W. Further, the upper edge electrode 620 may be an opposing electrode facing each other the lower edge electrode 350 described above.

The second base 610 may be installed above the chuck 310 and the substrate W supported by the chuck 310. The second base 610 may fix the position of the upper edge electrode 620. The second base 610 may be disposed between the upper edge electrode 620 and the temperature adjustment plate 710 which will be described below. The second base 610 may be coupled to the temperature adjustment plate 710 which will be described below and the upper edge electrode 620 may be coupled to the second base 610. Accordingly, the upper edge electrode 620 may be coupled to the temperature adjustment plate 710 via the second base 610.

The second base 610 may have a ring shape when viewed from above. The top surface and the bottom surface of the second base 610 may have a flat shape. When viewed from above, the second base 610 may have a shape surrounding the first base 510. An inner diameter of the second base 610 may gradually increase from top to bottom. The second base 610 may be provided to be spaced apart from the first base 510. The second base 610 may be spaced apart from the first base 510 to form a gap space. The gap space may form a part of the gas channel in which second gas G2 supplied by the second gas supply unit 830, which will be described below, flows. Further, the second bas 610 may be made of a material including metal. For example, the second base 610 may be made of a material including aluminum.

The temperature adjustment unit 700 may include the temperature adjustment plate 710 and a fluid supply module (not illustrated). The fluid supply module may supply and discharge cooling fluid into and out of a flow path 712 formed in the temperature adjustment plate 710.

The gas supply unit 800 may supply gas to the internal space 102. The gas supply unit 800 may supply the first gas G1 and the second gas G2 to the internal space 102. The gas supply unit 800 may include a first gas supply unit 810 and a second gas supply unit 830.

The first gas supply unit 810 may supply the first gas G1 to the internal space 102. The first gas G1 may be inert gas, such as nitrogen. The first gas supply unit 810 may supply the first gas G1 to the center region of the substrate W supported by the chuck 310. The first gas supply unit 810 may include a first gas supply source 812, a first gas supply line 814, and a first valve 816. The first gas supply source 812 may store the first gas G1 and/or supply the first gas G1 to the first gas supply line 814. The first gas supply line 814 may be connected with the flow path formed in the dielectric plate 520. The first valve 816 may be installed in the first gas supply line 814. The first valve 816 may be an on/off valve, or provided as a flow rate adjustment valve. The first gas G1 supplied by the first gas supply source 812 may be supplied to the center region of the upper surface of the substrate W through the flow path formed in the dielectric plate 520.

The second gas supply unit 830 may supply the second gas G2 to the internal space 102. The second gas G2 may be process gas excited to a plasma state. The second gas supply unit 830 may supply the second gas G2 to the edge region of the substrate W through the gas channel formed by spacing the dielectric plate 520, the first base 510, the upper edge electrode 620, and the second base 610 provided above the upper portion of the edge region of the substrate W supported by the chuck 310 apart from each other. The second gas supply unit 830 may include a second gas supply source 832, a second gas supply line 834, and a second valve 836. The second gas supply source 832 may store the second gas G2 and/or supply the second gas G2 to the second gas supply line 834. The second gas supply line 814 may supply the second gas G2 to the gap space functioning as the gas channel. The second valve 836 may be installed in the second gas supply line 834. The second valve 836 may be an on/off valve, or provided as a flow rate adjustment valve. The second gas G2 supplied by the second gas supply source 832 may be supplied to the edge region of the top surface of the substrate W through the second flow path 602.

The controller 800 may control the substrate processing apparatus 1000. The controller 900 may control the substrate processing apparatus 1000 to perform the plasma treatment process described below.

The controller 900 may control the substrate processing apparatus 1000 so as to perform a substrate processing method described below. Further, the control unit 900 may include a process controller formed of a microprocessor (computer) that executes the control of the substrate processing apparatus 1000, a user interface formed of a keyboard in which an operator performs a command input operation or the like in order to manage the substrate processing apparatus 1000, a display for visualizing and displaying an operation situation of the substrate processing apparatus 1000, and the like, and a storage unit storing a control program for executing the process executed in the substrate processing apparatus 1000 under the control of the process controller or a program, that is, a treatment recipe, for executing the process in each component according to various data and processing conditions. Further, the user interface and the storage unit may be connected to the process controller. The processing recipe may be memorized in a storage medium in the storage unit, and the storage medium may be a hard disk, and may also be a portable disk, such as a CD-ROM or a DVD, or a semiconductor memory, such as a flash memory.

The following describes in detail a method of processing a substrate W by the substrate processing apparatus 1000. The controller 900 may control the gas supply unit 800, the power member 320, the power source 540, and the like to enable the substrate processing apparatus 1000 to perform the method of processing the substrate W described below.

FIG. 8 is a diagram illustrating the substrate processing apparatus of FIG. 2 performing a plasma treatment process. Referring to FIG. 8, the substrate processing apparatus 1000 according to an exemplary embodiment of the present invention may process an edge region of the substrate W. For example, the substrate processing apparatus 1000 may process the edge region of the substrate W by generating plasma P in the edge region of the substrate W. For example, the substrate processing apparatus 1000 may perform a bevel etch process of processing the edge region of the substrate W.

In order to perform the bevel etch process on the substrate W, the drive member 370 may move the chuck 310 in an upper direction to decrease a gap between the substrate W and the dielectric plate 520.

When the substrate processing apparatus 1000 processes the edge region of the substrate W, the first gas supply unit 810 may supply the first gas G1 to a center region of the substrate W and the second gas supply unit 830 may supply the second gas G2 to the edge region of the substrate W. The second gas G2 supplied by the second gas supply unit 830 is process gas, so that the second gas G2 may be excited in a plasma P state to treat the edge region of the substrate W. For example, a thin film on the edge region of the substrate W may be etching-processed by the plasma P. Further, the first gas G1 supplied to the center region of the substrate W is inert gas, and the first gas G1 prevents the second gas G2 from being introduced to the center region of the substrate W, thereby further improving processing efficiency for the edge region of the substrate W.

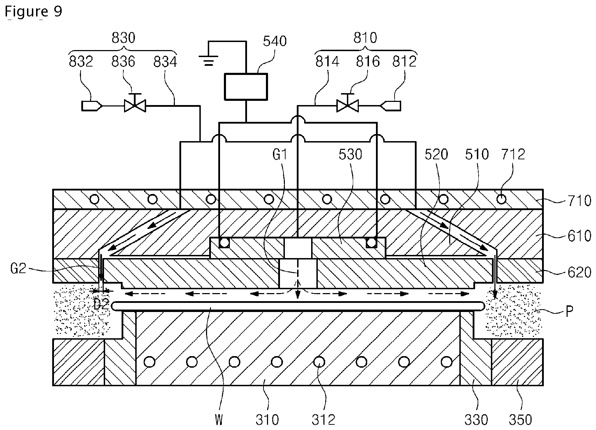

Further, when the power source 540 does not apply power to the moving member 535, the gap between the dielectric plate 520 and the upper edge electrode 620 may be a first gap D1. As needed, when it is desired to move the location where the plasma P is generated away from the edge region of the substrate W, reduce the amount of plasma P generated at the edge region of the substrate W, and/or reduce the size of the region in which the plasma P is generated, the power source 540 may apply power to the moving member 535. In this case, the gap between the dielectric plate 520 and the upper edge electrode 620 may be a second gap D2, as illustrated in FIG. 9. The second gap D2 may be a smaller gap than the first gap D1. When the dielectric plate 520 is moved in a lateral direction, the location where the plasma P is generated may change in a direction away from the substrate W because the dielectric plate 520 is provided with an insulating material. Furthermore, the gap between the dielectric plate 520 and the upper edge electrode 620 may vary as the dielectric plate 520 is moved, such that the flow rate of the process gas G2 supplied per unit time may be less. Accordingly, the size of the region in which the plasma P is generated may be smaller, and the amount of plasma P generated may also be smaller.

Furthermore, the change in the gap between the dielectric plate 520 and the upper edge electrode 620 may vary during the processing of the substrate W by the plasma P. Thus, both an inner region and an outer region of the edge region of the substrate W may be processed in a first time period for the substrate W, and only an outer region of the edge region of the substrate W may be processed in a second time period for the same substrate W.

In other words, by moving the dielectric plate 520, the supply flow rate per unit time of the process gas G2 supplied to the region in which the plasma P is generated and to the edge region of the substrate W may be adjusted.

According to the exemplary embodiment of the present invention, the region in which the plasma P is activated and the density of the plasma P generated may be adjusted without replacing configurations/components of the substrate processing apparatus 1000. Therefore, it is possible to solve the time lost in replacing configurations/components.

Furthermore, the region processed by the plasma P for one substrate W can be changed. That is, at least two distinct processes can be performed on one substrate W, thereby increasing the choice of processing method for the edge region of the substrate W.

Furthermore, in the above example, the present invention has been described based on the case where the dielectric plate 520 is moved while performing a processing process by using plasma P on a single substrate W as an example, but the present invention is not limited thereto. For example, when a first substrate is placed in the chuck 310, the power source 540 can be controlled such that the gap between the dielectric plate 520 and the upper edge electrode 620 is a first gap, and when a second substrate that is different from the first substrate is placed in the chuck 310, the power source 540 can be controlled such that the gap between the dielectric plate 520 and the upper edge electrode 620 is a second gap that is different from the first gap.

Furthermore, in the above example, the present invention has been described based on the case where all of the segmented dielectric plates 520 moves together as an example, but the present invention is not limited thereto. For example, the power source 540 may apply power only to selected moving member 535 among the moving members 535 to move only the selected dielectric plate 520 among the segmented dielectric plates 520. For example, only the first dielectric plate 521 among the first dielectric plate 521 to the fourth dielectric plate 524 may be moved.

In the above example, the present invention has been described based on the case where the moving member 535 is a piezo motor, but the present invention is not limited thereto. For example, the moving member 535 can be variously modified to be any known device capable of moving the segmented dielectric plates 520 (for example, step motor, pneumatic cylinder, or hydraulic cylinder).

In the foregoing example, the present invention has been described based on the case where the chuck 310 moves in the vertical direction and the positions of the dielectric plate 520 and the upper edge electrode 620 are fixed has been described as the example, but the present invention is not limited thereto. For example, the position of the chuck 310 may be fixed and the dielectric plate 520 may be configured to be movable in the vertical direction. Further, both the chuck 310 and the dielectric plate 520 may be configured to be movable in the vertical direction.

Further, in the foregoing example, the present invention has been described based on the case where the upper edge electrode 620 and the lower edge electrode 350 are grounded as an example, but the present invention is not limited thereto. For example, the upper edge electrode 620 and/or the lower edge electrode 350 may be coupled to an RF power source.

The method of generating the plasma P by the substrate processing apparatus 1000 described in the foregoing example may be an Inductive Coupled Plasma (ICP) method. Further, the method of generating the plasma P by the substrate processing apparatus 1000 may be a Capacitor Couple Plasma (CCP) method. Further, the substrate processing apparatus 1000 may generate the plasma P by using both the ICP method and the CCP method or by using a selected method between the ICP method and the CCP method. Further, the substrate processing apparatus 1000 may also generate the plasma P by using a remote plasma method.

The foregoing detailed description illustrates the present invention. Further, the above content illustrates and describes the exemplary embodiment of the present invention, and the present invention may be used in various other combinations, modifications, and environments. That is, the foregoing content may be modified or corrected within the scope of the concept of the invention disclosed in the present specification, the scope equivalent to that of the invention, and/or the scope of the skill or knowledge in the art. The foregoing exemplary embodiment describes the best state for implementing the technical spirit of the present invention, and various changes required in the specific application field and use of the present invention are possible. Accordingly, the detailed description of the invention above is not intended to limit the invention to the disclosed exemplary embodiment. Further, the accompanying claims should be construed to include other exemplary embodiments as well.

### Description of the reference number

Substrate processing apparatus: 1000
Housing: 100
First housing: 110
Second housing: 120
Rotation joint: 130
1st all-joint division: 131
1-1 hinge portion: 131a
1-2 hinge portion: 131b
2nd all-joint division: 132
2-1 hinge portion: 132b
2-2 hinge part: 132b
First bearing: 133a
Second bearing: 133b
First hinge pin: 134a
Second hinge pin: 134b
Support unit: 300
chuck: 310
Insulating ring: 330
Lower edge electrode 350
Dielectric plate unit: 500
First base: 510
Dielectric plate: 520
First dielectric plate: 521
Second dielectric plate: 522
Third dielectric plate: 523
Fourth dielectric plate: 524
Moving module: 530
Body: 531
First through groove: 532
Second through groove: 533
Insertion groove: 534
Moving member: 535
Power source: 540
Upper electrode unit: 600
Temperature adjustment unit: 700
Temperature adjustment plate: 710
Flow path: 712
Gas supply unit: 800
Controller: 900

## Claims

1. An apparatus for processing a substrate, the apparatus comprising:
a housing having an internal space;
a chuck for supporting a substrate in the internal space;
a gas supply unit for supplying process gas to an edge region of the substrate; and
an edge electrode for generating plasma from the process gas in the edge region of the substrate supported on the chuck; and
a dielectric plate facing the substrate supported on the chuck, the dielectric plate being movably segmented.

2. The apparatus of claim 1, further comprising:
a moving module provided on top of the dielectric plates, and for moving positions of the segmented dielectric plates.

3. The apparatus of claim 2, wherein the moving module includes:
a body to which the segmented dielectric plates are coupled; and
a moving member installed in the body, and for moving at least one of the segmented dielectric plates.

4. The apparatus of claim 3, wherein the body includes:
a through groove formed while penetrating a top surface and a bottom surface of the body; and
an insertion groove formed in a region including the through groove when viewed from above, and recessed a set depth from the top surface of the body.

5. The apparatus of claim 4, wherein the insertion groove is provided with the moving member.

6. The apparatus of claim 5, wherein the moving member is a piezo motor, and
the apparatus further comprises a power source for applying power to the moving member.

7. The apparatus of claim 6, wherein a size of the insertion groove viewed from above is greater than a size of the moving member before the power is applied and is less than a size of the moving member after the power is applied.

8. The apparatus of claim 7, wherein the plurality of through grooves and the plurality of insertion grooves are formed in the body and are spaced apart from each other along a circumferential direction of the body when viewed from above.

9. The apparatus of any one of claims 6 to 8, wherein the edge electrode includes:
an upper edge electrode having a shape surrounding the dielectric plate, when viewed from above, and configured to be spaced apart from the dielectric plate; and
a lower edge electrode having a shape surrounding the chuck, when viewed from above, and disposed below the substrate supported on the chuck.

10. The apparatus of claim 9, wherein the gas supply unit is configured to supply the process gas to a space between the upper edge electrode and the dielectric plate.

11. The apparatus of claim 10, further comprising:
a controller,
wherein the controller controls the power source such that a gap between the dielectric plate and the upper edge electrode is a first gap when a first substrate is placed in the chuck, and
controls the power source such that the gap between the dielectric plate and the upper edge electrode is a second gap that is different from the first gap when a second substrate that is different from the first substrate is placed in the chuck.

12. The apparatus of claim 10, further comprising:
a controller,
wherein the controller controls the gas supply unit to generate the plasma in the edge region of the substrate supported on the chuck, and
controls the power source so that the gap between the dielectric plate and the upper edge electrode is changed during processing of the substrate by the plasma.

13. The apparatus of any one of claims 8 to 12, wherein a top surface of any one of the segmented dielectric plates has a stepped shape so as to overlap a bottom surface of the other of the segmented dielectric plates, when viewed from above.

14. The apparatus of claim 13, wherein when viewed from above, a width of a region of the stepped top surface facing the bottom surface is greater than a gap between the dielectric plates moved by the moving module.

15. The apparatus of any one of claims 2 to 8, wherein a bottom surface of any one of the segmented dielectric plates has a stepped shape so as to overlap a top surface of the other of the segmented dielectric plates, when viewed from above.

16. The apparatus of claim 15, wherein when viewed from above, a width of a region of the stepped bottom surface facing the top surface is greater than a gap between the dielectric plates moved by the moving module.

17. The apparatus of any one of claims 1 to 8, wherein the dielectric plate has a circular plate shape with an opening formed in a central region, and
a bottom surface of a first dielectric plate among the segmented dielectric plates has a stepped shape so as to overlap a top surface of the second dielectric plate adjacent to the first dielectric plate, and
a top surface of the first dielectric plate has a stepped shape so as to overlap a bottom surface of a fourth dielectric plate adjacent to the first dielectric plate at an opposite side to the second dielectric plate.

18. A method of processing a substrate by using a substrate processing apparatus including a chuck for supporting a substrate, an edge electrode for generating plasma in an edge region of the substrate, a dielectric plate disposed to face a top surface of the substrate supported on the chuck, the dielectric plate being movable in a lateral direction, a moving module for moving the dielectric plate, a gas supply unit for supplying process gas excited to a plasma state to the edge region of the substrate supported on the chuck - the gas supply unit being configured to supply the process gas to a space between the edge electrode and the dielectric plate, the method comprising:
generating plasma in an edge region of a substrate supported on a chuck, and moving at least one of the segmented dielectric plates in a lateral direction to regulate a region in which the plasma is generated and a supply flow rate at which the process gas is supplied per unit time.

19. The method of claim 18, wherein the moving of the dielectric plate is performed while the plasma is generated and the substrate is processed.

20. The method of claim 18, comprising:
moving at least one of the segmented dielectric plates so that a gap between the dielectric plate and the edge electrode is a first gap when the substrate supported on the chuck is a first substrate, and a gap between the dielectric plate and the edge electrode is a second gap that is different from the first gap when the substrate supported on the chuck is a second substrate that is different from the first substrate.
